# EUROPEAN PATENT APPLICATION

(11) **EP 2 717 327 A2**
(43) Date of publication of application: **09.04.2014**
(21) Application number: 12788816.2
(22) Date of filing: 23.05.2012
(51) Int. Cl.: H01L 31/042, H01L 31/0224, H01L 31/0236, H01L 31/18

(54) **SOLAR CELL AND METHOD FOR MANUFACTURING SAME**

(30) Priority: 23.05.2011 KR 20110048633
(71) Applicant: Kim, Byung Kuk, Gyeonggi-do 462-828 (KR); Lee, Jae Sung, Gyeonggi-do 411-726 (KR); Soh, Theng Tat, Waterfall Gardens 268824 (SG)
(72) Inventor: KIM, Byung Kuk, Gyeonggi-do, 462-828 (KR); LEE, Jae Sung, Gyeonggi-do 411-726 (KR)
(74) Representative: Zardi, Marco
(86) International application number: PCT/KR2012/004088
(87) International publication number: WO 2012/161521

(57) **Abstract**

Disclosed are a solar cell and a method for fabricating the same. The solar cell according to the present invention comprises a substrate including a plurality of unit cell regions and a plurality of wiring regions positioned between the unit cell regions; a first semiconductor layer being formed on any one unit cell area of the plurality of unit cell regions; a partition layer being formed on the first semiconductor layer and partitioning a region on the first semiconductor layer into first and second regions; a separation layer being formed on any one wiring region of the plurality of wiring regions; a first electrode layer being formed on the first region of the first semiconductor layer; a second semiconductor layer being formed on the second region of the first semiconductor layer; a second electrode layer being formed on the second semiconductor layer; and an electrode connection layer being connected to one end of the second electrode layer as the same layer and being formed on the separation layer.

## Description

### FIELD OF THE INVENTION

The present invention relates to a solar cell and a method for fabricating the same. More specifically, the present invention relates to a solar cell that can improve photoelectric transformation efficiency by forming both electrodes (anode and cathode) made of metal on the opposite side of a sunlight incident surface, as well as a method for fabricating the solar cell.

### BACKGROUND

Recently, as natural resources such as oil and coal are expected to be exhausted and environmental and stability issues associated with nuclear power generation are being raised, interest is being focused on alternative eco-friendly energy. In eco-friendly energy generation, sunlight energy is an inexhaustible and permanent energy source that does not cause problems with environmental pollution and stability and costs less to maintain. Therefore, it may be advantageously applied to a variety of fields such as solar cells, modules and fabrication equipment.

Solar cells for sunlight power generation are photoelectric transformation elements that use electromotive force generated by diffusion of minority carriers excited by sunlight in p-n junction semiconductors. According to materials, they may be generally categorized into silicone solar cells, inorganic solar cells (compound solar cells) that use inorganic materials such as compound semiconductors, and organic solar cells that include organic materials.

Among them, a silicone solar cell that uses crystalline silicone has high generation efficiency while the material costs high and the processes are complicated, so that the reduction of the unit cost of production is limited. Therefore, a thin film solar cell formed by depositing amorphous silicon or compound semiconductor on a low-cost substrate such as glass or plastic is drawing attention. In particular, the thin film solar cell is advantageously scalable to large-area applications, and may enable the production of a flexible solar cell depending on the material of the substrate.

A superstrate-type compound solar cell among thin film solar cells is fabricated by sequentially stacking a front electrode such as transparent conducting oxide (TCO), an n-type CdS layer, a p-type CdTe layer, and a back electrode such as Al on a glass substrate. Further, a substrate-type compound solar cell among thin film solar cells is fabricated by sequentially stacking a front electrode such as Mo, a p-type CIGS (copper indium gallium selenide) layer, an n-type CdS layer, and a transparent electrode such as TCO on a glass substrate. In these compound solar cells, holes and electrons are generated by sunlight in a CdTe or CIGS layer, which is an optical absorption layer, and are diffused between the front and back electrodes to induce a voltage difference, thereby generating electromotive force.

However, the conventional compound solar cells have a problem of deterioration in photoelectric transformation efficiency caused by that the front or back electrode formed on the sunlight incident surface decreases the amount of optical absorption. Further, electrons or holes are collected through a transparent electrode having a relatively higher resistance than a metal electrode, and unit solar cells are connected with each other, thereby also causing the problem of deterioration in photoelectric transformation efficiency.

### SUMMARY OF THE INVENTION

Accordingly, the present invention has been conceived overcome the problems in the prior art as described above, and one object of the present invention is to provide a solar cell and a method for fabricating the same, wherein photoelectric transformation efficiency can be maximized by forming both electrodes (anode and cathode) on the opposite side of a sunlight incident surface to increase the amount of sunlight absorption.

Further, another object of the invention is to provide a solar cell and a method for fabricating the same, wherein photoelectric transformation efficiency can be maximized by forming both electrodes (anode and cathode) with metal having a relatively lower resistance than TCO to collect electrons or holes, and connecting unit cells with each other.

Furthermore, yet another object of the invention is to provide a solar cell and a method for fabricating the same, wherein photoelectric transformation efficiency and reliability can be maximized by curing an optical absorption layer before forming two electrodes (anode and cathode) to promote polycrystallization of the optical absorption layer at a sufficiently high curing temperature, and at the same time preventing cracks of the two electrodes that may be generated by the high-temperature curing process.

According to one aspect of the invention to achieve the objects as described above, there is provided a solar cell, comprising a substrate including a plurality of unit cell regions and a plurality of wiring regions positioned between the unit cell regions; a first semiconductor layer being formed on any one unit cell region of the plurality of unit cell regions; a partition layer being formed on the first semiconductor layer and partitioning a region on the first semiconductor layer into first and second regions; a separation layer being formed on any one wiring region of the plurality of wiring regions; a first electrode layer being formed on the first region of the first semiconductor layer; a second semiconductor layer being formed on the second region of the first semiconductor layer; a second electrode layer being formed on the second semiconductor layer; and an electrode connection layer being connected to one end of the second electrode layer as the same layer and being formed on the separation layer.

According to another aspect of the invention, there is provided a method for fabricating a solar cell, comprising (a) providing a substrate including a plurality of unit cell regions and wiring regions positioned between the unit cell regions; (b) forming a first semiconductor layer on any one unit cell region of the plurality of unit cell regions; (c) simultaneously forming a partition layer on the first semiconductor layer and a separation layer on any one wiring region of the plurality of wiring regions; (d) when a region on the first semiconductor layer is partitioned into first and second regions by the partition layer, forming a second semiconductor layer on the second region; and (e) forming a first electrode layer on the first semiconductor layer, a second electrode layer on the second semiconductor layer, and an electrode connection layer on the separation layer.

According to yet another aspect of the invention, there is provided a method for fabricating a solar cell, comprising (a) providing a substrate including a plurality of unit cell regions and a plurality of wiring regions positioned between the unit cell regions; (b) forming a first semiconductor layer on any one unit cell region of the plurality of unit cell regions; (c) forming a separation layer on any one wiring region of the plurality of wiring regions; (d) when a region on the first semiconductor layer is partitioned into first and second regions by a partition layer to be formed on the first semiconductor layer, forming a second semiconductor layer on the second region; (e) forming the partition layer on the first semiconductor layer; and (f) forming a first electrode layer on the first semiconductor layer, a second electrode layer on the second semiconductor layer, and an electrode connection layer on the separation layer.

According to the present invention, photoelectric transformation efficiency is improved by forming both electrodes (anode and cathode) on the opposite side of a sunlight incident surface to increase the amount of sunlight absorption.

According to the present invention, photoelectric transformation efficiency is improved by forming both electrodes (anode and cathode) with metal having a relatively lower resistance than TCO to collect electrons or holes, and connecting unit cells with each other.

According to the present invention, photoelectric transformation efficiency and reliability are improved by curing an optical absorption layer before forming two electrodes (anode and cathode) to promote polycrystallization of the optical absorption layer at a sufficiently high curing temperature, and at the same time preventing cracks of the two electrodes that may be generated by the high-temperature curing process.

### BRIEF DESCRIPTION OF THE DRAWINGS

Fig. 1 is a diagram illustrating the entire configuration of a solar cell according to one embodiment of the present invention;
Figs. 2a to 2h are diagrams sequentially illustrating procedures of fabricating a solar cell according to one embodiment of the present invention;
Fig. 3 is a diagram illustrating the entire configuration of a solar cell including an S-shaped partition layer according to one embodiment of the present invention;
Fig. 4(a) is a diagram illustrating a solar cell in which one side of a substrate is textured according to one embodiment of the present invention, and Fig. 4(b) is an enlarged diagram illustrating a solar cell in which nano-holes are formed on one side of a substrate according to one embodiment of the present invention;
Fig. 5 is a diagram illustrating a solar cell in which a low reflection layer is formed on an optical incident surface of a substrate according to one embodiment of the present invention;
Fig. 6 is a diagram illustrating a solar cell in which a low reflection layer is formed between a substrate and a first semiconductor layer according to one embodiment of the present invention;
Fig. 7 is a diagram illustrating a solar cell in which an insulation layer is formed according to one embodiment of the present invention; and
Figs. 8a to 8g are diagrams sequentially illustrating procedures of fabricating a solar cell according to another embodiment of the present invention.

### DETAILED DESCRIPTION OF THE PREFERRED EMBODIMENTS

In the following detailed description of the invention, references are made to the accompanying drawings that show, by way of illustration, specific embodiments in which the invention may be practiced. These embodiments are described in sufficient detail to enable those skilled in the art to practice the invention. It is to be understood that the various embodiments of the invention, although different from each other, are not necessarily mutually exclusive. For example, specific shapes, structures, or characteristics described herein may be implemented as modified from one embodiment to another embodiment without departing from the spirit and the scope of the invention. Furthermore, it shall be understood that the locations or arrangements of individual elements within each embodiment may be also modified without departing from the spirit and the scope of the invention. Therefore, the following detailed description is not to be taken in a limiting sense, and the scope of the invention is to be taken as encompassing the scope of the appended claims and all equivalents thereof. In the drawings, like reference numerals refer to the same or similar elements throughout the several views, and certain features such as length, area, thickness and shape may be exaggerated for convenience.

Hereinafter, preferred embodiments of the present invention will be described in detail with reference to the accompanying drawings to enable those of ordinary skill in the art to easily implement the invention.

In the present disclosure, a unit cell region (a) refers to a region in which a photoelectric element (a semiconductor layer) is positioned between electrodes (first and second electrode layers) so that photoelectric transformation of a solar cell substantially takes place.

Further, in the present disclosure, a wiring region (b) refers to a region that is positioned between unit cell regions (a), separates the unit cell regions, and at the same time performs electrical connection (e.g., serial connection), which may be understood as a dead region in which photoelectric transformation of a solar cell does not substantially take place.

In the following detailed description, reference will be made to a cross section illustrating only a part of a solar cell for convenience.

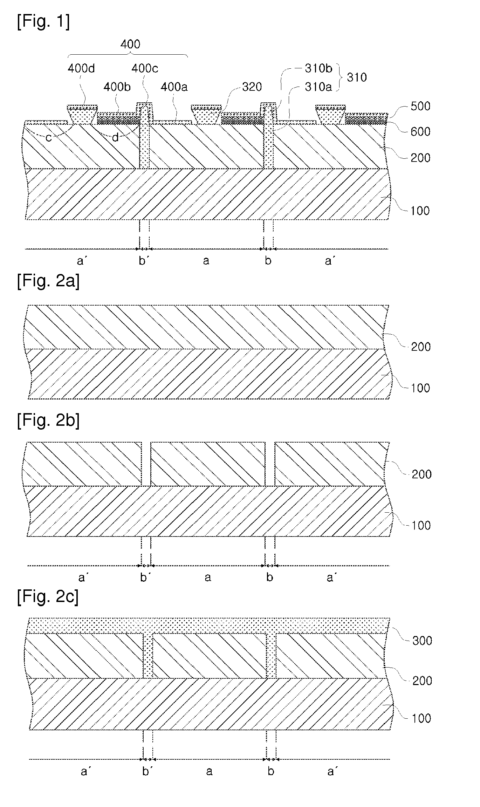

Fig. 1 is a diagram illustrating the entire configuration of a solar cell according to one embodiment of the present invention.
Figs. 2a to 2h are diagrams sequentially illustrating procedures of fabricating a solar cell according to one embodiment of the present invention.

First, with reference to Figs. 1 and 2a, a substrate 100, including a plurality of unit cell regions (a) and a plurality of wiring regions (b) positioned between the unit cell regions (a), is prepared.

The substrate 100 may be made of transparent glass, but the present invention is not limited thereto. For example, in addition to glass, the substrate may be made of the material such as plastic or polymer with high optical transmittance.

Next, a first semiconductor layer 200 is formed on the entire upper surface of the substrate 100. The first semiconductor layer 200 may perform a function of receiving light in the unit cell regions (a) and producing electric power in the following processes. The first semiconductor layer 200 is preferably a p-type semiconductor layer. The first semiconductor layer 200 may be a compound semiconductor layer, which may be, for example, any one of CIGS (copper indium gallium selenide), CdTe and CZTS (copper zinc tin selenide). Herein, CIGS may be any one of CuInSe₂, CuInS₂, CuGaSe₂, CuGaS₂, Cu(In,Ga)Se₂, Cu(In,Ga)S₂ and Cu(In,Ga)(Se,S)₂ in the form of Cu(In,Ga)(Se,S)₂. In particular, Cu(InGa)Se₂ is preferred if the first semiconductor layer 200 is CIGS, and Cu₂ZnSnSe₄ is preferred if the first semiconductor layer 200 is CZTS.

The method of forming the first semiconductor layer 200 may include physical vapor deposition (PVD) such as thermal evaporation, e-beam evaporation and sputtering, chemical vapor deposition (CVD) such as LPCVD, PECVD and metal organic chemical vapor deposition (MOCVD), electroplating, or printing such as ink jet printing and screen printing. However, the present invention is not limited thereto, and well-known thin film forming methods may be used without limitation.

Subsequently, with reference to Fig. 2b, the first semiconductor layer 200 is patterned. The method of patterning the first semiconductor layer 200 may include laser scribing, photolithography or the like. However, the present invention is not limited thereto, and well-known patterning methods can be used without limitation.

The region in which the first semiconductor layer 200 is formed on the substrate 100 by patterning the first semiconductor layer 200 may become the unit cell region (a), and the region in which the first semiconductor layer 200 is not formed on the substrate 100 may become the wiring region (b).

Thereafter, the first semiconductor layer 200 is cured at a high temperature. By the curing, an amorphous microstructure existing in the first semiconductor layer 200 may be changed to a polycrystalline microstructure. Of course, the first semiconductor layer 200 may be patterned after it is cured. The purpose of the curing is to provide the first semiconductor layer 200 with a higher ratio of polycrystalline microstructure.

In this manner, the present invention performs a process of curing the first semiconductor layer 200 at an initial stage of fabricating the solar cell, i.e., before an electrode layer is formed. Therefore, polycrystallization of the first semiconductor layer 200 is promoted by sufficiently raising the curing temperature, and at the same time, cracks in an electrode layer 400 caused by the high-temperature curing process may be prevented so as to implement a solar cell wherein photoelectric transformation efficiency and reliability are improved.

Next, with reference to Fig. 2c, a negative photoresist layer 300 is formed on the first semiconductor layer 200 and the wiring regions (b). The negative photoresist layer 300 may form a separation layer 310 and a partition layer 320 by a double-sided photolithography process to be described below.

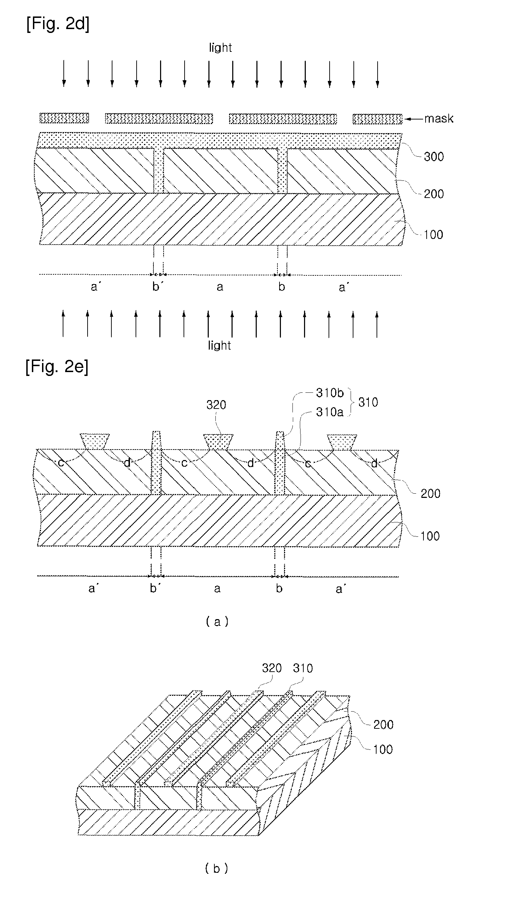

Subsequently, with reference to Fig. 2d, a double-sided exposure is performed on the negative photoresist layer 300. Herein, the upper side of the negative photoresist layer 300 is exposed using a separate photo mask, and the lower side of the negative photoresist layer 300 is exposed using the first semiconductor layer 200 as a photo mask.

Thereafter, with reference to Fig. 2e(a), unexposed portions of the negative photoresist layer 300 are removed using a developer. As a result, the partition layer 320 may be formed on the first semiconductor layer 200 of the unit cell regions (a), and the separation layer 310 may be formed on the wiring regions (b). Fig. 2e(b) is a diagram illustrating Fig. 2e(a) in three dimensions. Meanwhile, the partition layer 320 may be formed on the upper part of the first semiconductor layer 200 using a printing method other than the above-described method.

The partition layer 320 is a remaining portion exposed by a photo mask when the upper side of the negative photoresist layer 300 is exposed, and it may be formed on the first semiconductor layer 200 so that the cross section thereof has a reverse trapezoidal (or reverse tapered) shape. The region on the first semiconductor layer 200 may be partitioned into a first region (c) and a second region (d) by the partition layer 320.

The separation layer 310 is a remaining portion exposed by the first semiconductor layer 200 serving as a photo mask when the lower side of the negative photoresist layer 300 is exposed. The separation layer 310 may be formed to include a first separation layer 310a formed on the wiring regions (b) to have a thickness substantially the same as that of the first semiconductor layer 200, and a second separation layer 310b formed at one end of the first separation layer 310a as the same layer. The second separation layer 310b may be formed on the first separation layer 310a so that the cross section thereof has a trapezoidal (or tapered) shape.

In this manner, the present invention may form the separation layer 310 and the partition layer 320 by one photolithography process, i.e., by simultaneously exposing both sides of the negative photoresist layer 300, so as to implement a solar cell wherein the fabricating processes are simplified and the fabrication cost is reduced.

Meanwhile, as described above, the separation layer 310 and the partition layer 320 may be formed at the same time using a negative photoresist layer, but after the separation layer 310 is formed first regardless of a type of the photoresist layer, the partition layer 320 may be formed using a negative photoresist layer.

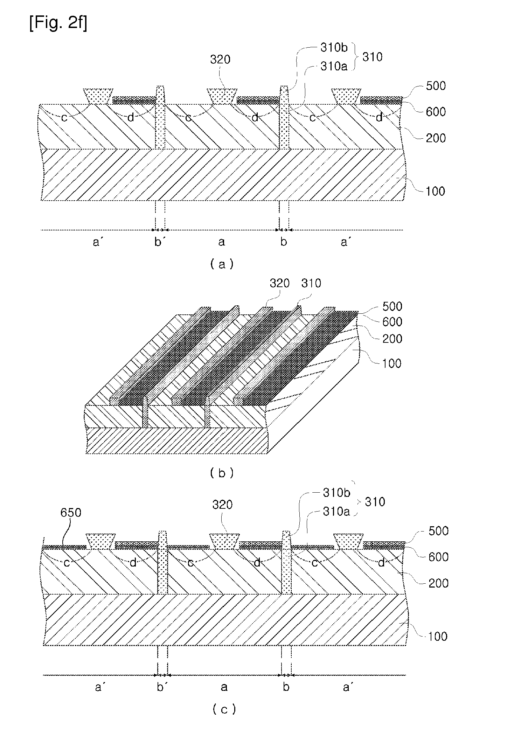

Subsequently, with reference to Fig. 2f(a), a second semiconductor layer 500 is formed on the second region (d) of the first semiconductor layer 200. The second semiconductor layer 500 is preferably an n-type semiconductor. The second semiconductor layer 500 may be any one of metal oxide such as ZnO and ZrO, metal nitride such as GaN, metal hydrate such as In(OH)ₓS_{y}, MeₓZn_{y}(OH)_{z}S_{q}, MeₓIn_{y}(OH)_{z}S_{q}, MeₓZn_{y}(OH)_{z}Se_{q} and MeₓIn_{y}(OH)_{z}Se_{q}, amorphous silicon, conducting polymer, and semiconducting organic material. The n-type second semiconductor layer 500 generates electromotive force from photoelectric transformation by forming a p-n junction with the p-type first semiconductor layer 200. Fig. 2f(b) is a diagram illustrating Fig. 2f(a) in three dimensions.

The second semiconductor layer 500 may be formed by depositing a thin film by physical vapor deposition (PVD) or chemical vapor deposition (CVD), and then patterning the thin film by photolithography. In addition, without using photolithography, the second semiconductor layer 500 may be formed by ink jet printing, screen printing, direct deposition using a shadow mask, or the like. However, the present invention is not limited to the above-described methods, and well-known thin film forming and patterning methods may be used without limitation.

Meanwhile, referring again to Fig. 2f(a), a buffer layer 600 may be further formed between the first semiconductor layer 200 and the second semiconductor layer 500. An energy band of the buffer layer 600 ranges between those of the first semiconductor layer 200 and the second semiconductor layer 500, and may increase the efficiency of the p-n junction. The buffer layer 600 may be any one of metal, metal alloy, metal oxide such as ZnOₓ, metal nitride such as GaN and MeₓGa_{y}N_{z}, metal hydrate such as Zn(OH)ₓ, metal sulfide such as CdS, ZnSₓ, In(OH)ₓS_{y}, InS, MeₓZn_{y}(OH)_{z}S_{q} and MeₓIn_{y}(OH)_{z}S_{q}, metal selenide such as ZnSe, PbSe, MeₓZn_{y}(OH)_{z}Se_{q} and MeₓIn_{y}(OH)_{z}Se_{q}, conducting polymer, and semiconducting organic material. The buffer layer 600 may be formed in the same manner as the second semiconductor layer 500 as described above.

Further, referring again to Fig. 2f(a), due to the role of the separation layer 310 as a bank of the partition layer 320 and the second separation layer 310b, the second semiconductor layer 500 and the buffer layer 600 may be easily formed on the second region (d) of the first semiconductor layer 200.

Meanwhile, as illustrated in Fig. 2f(c), a hole injection layer 650 may be formed on the first region (c) of the first semiconductor layer 200 before forming the electrode layer 400. The hole injection layer 650 serves to smoothly inject holes and easily form an ohmic contact between the first semiconductor layer 200 and the electrode layer 400 (more specifically, the first electrode layer 400a). In addition, the hole injection layer 650 may serve as a passivation layer of the solar cell.

In order to form the ohmic contact, a work function of the hole injection layer 650 preferably ranges between those of the first semiconductor layer 200 and the first electrode layer 400a. Accordingly, the work function of the hole injection layer 650 may be from 3.0 eV to 7.0 eV, and the hole injection layer 650 may include any one of metal, metal oxide, metal nitride, metal sulfide, metal chelate, and organic material. The hole injection layer 650 may be formed in the same manner as the second semiconductor layer 500 as described above.

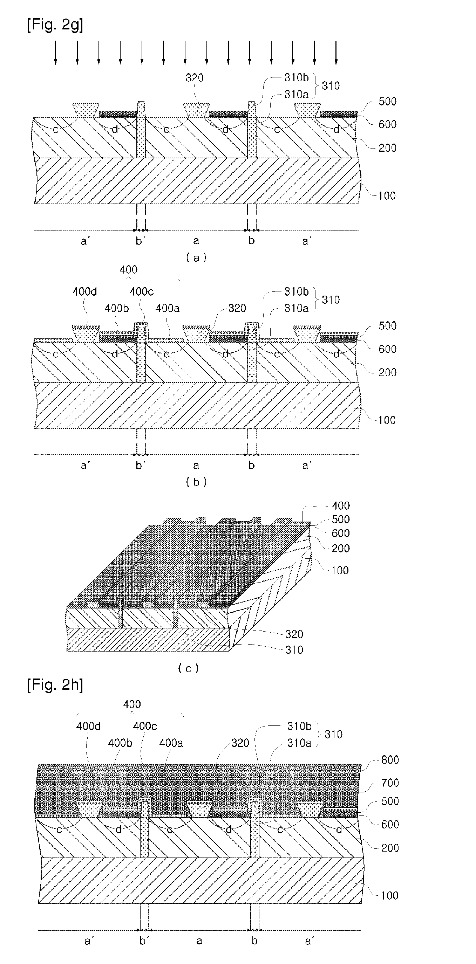

Next, with reference to Fig. 2g(a), the electrode layer 400 is formed on the first semiconductor layer 200, the separation layer 310, the partition layer 320 and the second semiconductor layer 500. The electrode layer 400 may be any one of Mo, Al, Ag, Au, Cu, Pt, Ni, Pd, Ti, Sn, Sb, Co, Tr, Ru, Rh, and Cd, or may be multiple layers made of two or more of the foregoing metals. However, the present invention is not limited thereto, and the electrode layer 400 may be made of well-known metals or metal alloys. The method of forming the electrode layer 400 may include physical vapor deposition (PVD), chemical vapor deposition (CVD) and printing. However, the present invention is not limited thereto, and well-known thin film forming methods may be used without limitation.

With reference to Fig. 2g(b), the electrode layer 400 may specifically include the first electrode layer 400a formed on the first region (c) of the first semiconductor layer 200, a second electrode layer 400b formed on the second semiconductor layer 500 on the second region (d) of the first semiconductor layer 200, and an electrode connection layer 400c formed on the second separation layer 310b. Fig. 2g(c) is a diagram illustrating Fig. 2g(b) in three dimensions.

Meanwhile, in the process of forming the electrode layer 400, an upper partition electrode layer 400d may be formed on the partition layer 320. Herein, since the electrode layer 400 is not formed on the side wall of the partition layer 320 due to the reverse trapezoidal shape of the partition layer 320, the first electrode layer 400a and the second electrode layer 400b may be formed to be electrically separated, without performing any additional patterning process after forming the electrode layer 400. That is, the first electrode layer 400a and the second electrode layer 400b may be self-patterned by the partition layer 320.

Further, as illustrated, the second electrode layer 400b of one unit cell region (a), the electrode connection layer 400c of one wiring region (b), and the first electrode layer 400a of a unit cell region (a') neighboring the one unit cell region (a) are all connected as the same layer. That is, the electrode connection layer 400c, which is connected as the same layer to one end of the second electrode layer 400b of the one unit cell region (a) and formed on the second separation layer 310b of the one wiring region (b), may also be connected as the same layer to one end of the first electrode layer 400a of the unit cell region (a') neighboring the one unit cell region (a). Therefore, the solar cell may be completed so that the one unit cell region (a) and the unit cell region (a') neighboring the one unit cell region (a) may be electrically connected in series through the wiring region (b) disposed between the one unit cell region (a) and the neighboring unit cell region (a'), and all the unit cell regions (a, a') on the substrate 100 may be electrically connected in series to perform photoelectric transformation.

In this manner, the present invention may realize a solar cell in which photoelectric transformation efficiency is improved by forming both of the electrode layers 400a and 400b on the opposite side of the sunlight incident surface to increase the amount of sunlight absorption, collecting electrons or holes through the two electrode layers 400a and 400b made of metal having a relatively lower resistance than TCO, and connecting the unit cells with each other.

Subsequently, with reference to Fig. 2h, a solar cell module may be formed by further forming a film layer 700 and a back surface layer 800 in the state of Fig. 2g. The film layer 700 may be any one of ethylene vinyl acetate (EVA), polyvinyl butyral (PVB), polyolefin, epoxy and silicone, and any materials other than described above may also be used as long as they have passivation properties. The back surface layer 800 may be any one of a back sheet and glass.

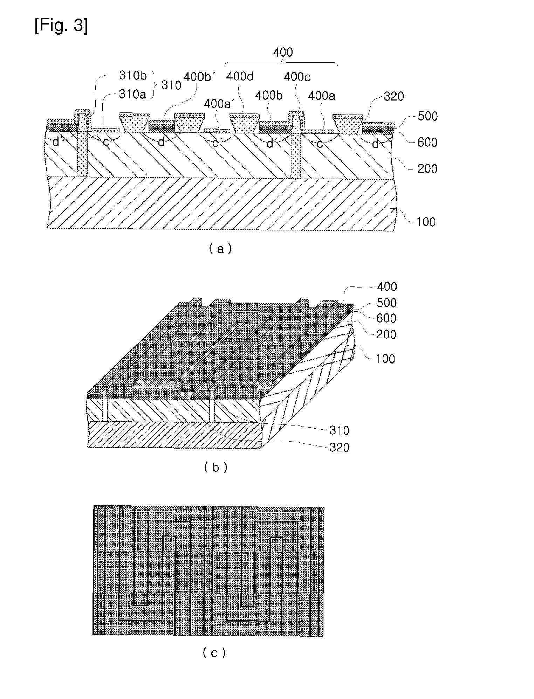

Fig. 3 is a diagram illustrating the entire configuration of a solar cell including an S-shaped partition layer according to one embodiment of the invention. Fig. 3(b) is a diagram illustrating Fig. 3(a) in three dimensions and Fig. 3(c) is a plan view of Fig. 3(b). In the following description of Fig. 3, only the differences with Fig. 1 will be described, and repetitive descriptions will be omitted.

With reference to Fig. 3, the solar cell of Fig. 3 is different from that of Fig. 1 only in terms of the plane shape of the partition layer 320. That is, with reference to Figs. 3(b) and 3(c), the present embodiment employs the partition layer 320 having an S-shaped plane shape and thus differs from the solar cell of Fig. 1 having the flat stripe-shaped partition layer 320. If the plane shape of the partition layer 320 is different, the occupied area of the partition layer 320 per unit cell region (a) becomes different, and the facing area of the first electrode layer 400a and the second electrode layer 400b, which are respectively formed on the first region (c) and the second region (d) partitioned by the partition layer 320, consequently becomes different. Comparing this with the solar cells of Figs. 1 and 3, the facing area of the first electrode layer 400a and the second electrode layer 400b of Fig. 3 is larger than that of Fig. 1 because the S-shaped partition layer 320 of Fig. 3 occupies a larger area per unit cell region (a) than the flat stripe-shaped partition layer 320 of Fig. 1,

In the present embodiment, as the facing area of the first electrode layer 400a and the second electrode layer 400b per unit cell region (a) increases as described above, the diffusion length of electrons and holes between two electrodes of the solar cell decreases so that the likelihood of recombination of the electrons and holes may be reduced. Therefore, since the recombination of the electrons and holes in the solar cell may cause photoelectric transformation efficiency to decrease, the present embodiment may implement a solar cell having enhanced photoelectric transformation efficiency by providing the S-shaped partition layer 320. Of course, in the present embodiment, the plane shape of the partition layer 320 is not limited to the S-shape, and any shape that can increase the facing area of the first electrode layer 400a and the second electrode layer 400b per unit cell region (a) may be employed.

Meanwhile, the present embodiment may provide the first electrode layer 400a and the second electrode layer 400b which are miniaturized by the S-shaped partition layer 320 in one unit cell region (a). Since two-dimensional behavior of electrons and holes approaches one-dimensional behavior as the structure (shape, area and the like) of the two electrodes in the solar cell are miniaturized, the likelihood of recombination of the electrons and holes may be reduced. Therefore, according to the present embodiment, the electrode structure can be miniaturized by providing the S-shaped partition layer 320 that may be formed with a simple process, instead of a complicated process to decrease the area of unit cell regions, so that the photoelectric transformation efficiency of the solar cell may be increased. Of course, in the present embodiment, the plane shape of the partition layer 320 is not limited to the S-shape, and any shape may be employed as long as it can miniaturize the structure of the first electrode layer 400a and the second electrode layer 400b per unit cell region (a). For example, the structure of the electrodes may be miniaturized more than as shown in Fig. 3 by providing two or more S-shaped partition layers 320 per unit cell region (a).

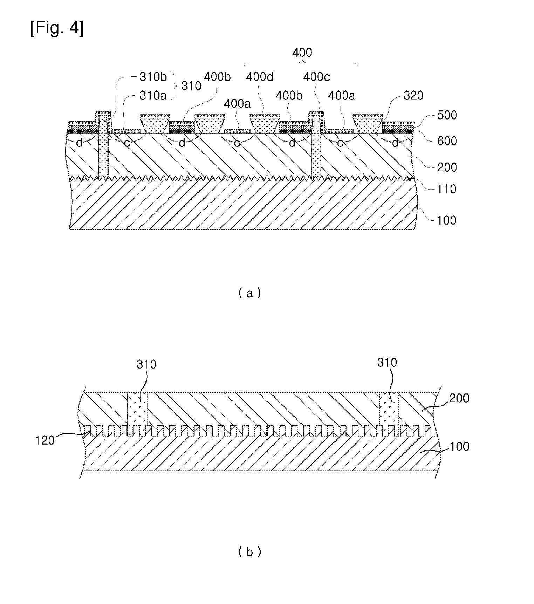

Fig. 4(a) is a diagram illustrating a solar cell in which one side of a substrate is textured according to one embodiment of the present invention, and Fig. 4(b) is an enlarged diagram illustrating a solar cell in which nano-holes are formed on one side of a substrate according to one embodiment of the present invention.

With reference to Fig. 4(a), the surface of the substrate 100 may have a texturing structure. Here, texturing is intended to prevent degradation of the solar cell properties caused by that light incident upon a surface of the substrate of the solar cell is reflected and optically lost. That is, a textured pattern 110 is formed on the surface of the substrate by roughening the surface of the substrate. For example, if the surface of the substrate is roughened by the texturing, light once reflected on the surface may be reflected again toward the solar cell. Therefore, the loss of light may be reduced and the amount of sunlight absorption may be increased to improve photoelectric transformation efficiency.

The texturing may be performed by wet etching, dry etching, sand blasting, or the like. Further, the texturing may also be performed by depositing or coating the material constituting the textured pattern 110. Provided that the texturing is performed by the latter method, the refractive index of the material constituting the textured pattern 110 preferably ranges within those of the substrate 100 and the first semiconductor layer 200.

With reference to Fig. 4(b), nano-holes 120 may be formed between the substrate 100 and the first semiconductor layer 200. Since the nano-holes 120 have a nano-scale size, they prevent reflection and maximize surface areas better than a general texturing structure so that the amount of sunlight absorption may be more increased and photoelectric transformation efficiency may be more improved by widening the range of wavelengths of the light received by the solar cell using a quantum effect. The nano-holes 120 may be formed on the substrate 100 by wet etching using etching masks or etching promoting particles, laser etching, nano-imprinting or the like.

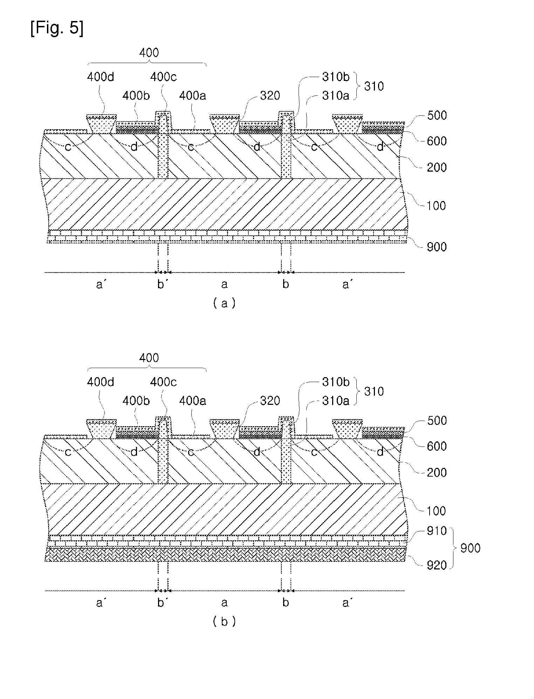

Fig. 5 is a diagram illustrating a solar cell in which a low reflection layer is formed on an optical incident surface of a substrate according to one embodiment of the present invention.

With reference to Fig. 5, a low reflection layer 900 may be formed on an optical incident layer of the substrate 100. The low reflection layer 900 prevents deterioration in photoelectric transformation efficiency of the solar cell caused by that sunlight incident upon the substrate is not absorbed by the first semiconductor layer 200 and is reflected to the outside immediately. The low reflection layer 900 may be formed as a single layer as illustrated in Fig. 5(a) or may be formed as multiple layers as illustrated in Fig. 5(b).

The low reflection layer 900 may be any one of MgF₂ and porous silicone oxide, but the present invention is not limited thereto. In order to effectively prevent the reflection of the sunlight using the refraction of light, it is preferred that the low reflection layer 900 uses a material of which the refractive index is lower than that of the substrate 100. If the low reflection layer 900 is formed as multiple layers, it is preferred to use materials of which the refractive indexes decrease upward from the substrate 100.

For example, if the low reflection layer 900 is formed as a single layer, it may be formed on the optical incident surface of a glass substrate with a refractive index of 1.52, wherein the low reflection layer 900 may be made of porous silicone oxide with a refractive index lower than glass (the refractive index of the porous silicone oxide may be adjusted from 1.2 to 1.5 depending on the density) or MgF₂ with a refractive index of 1.37. For another example, if the low reflection layer 900 is formed as multiple layers, a first low reflection layer 910 may be formed from porous silicone oxide with a refractive index lower than glass, and a second low reflection layer 920 may be formed from MgF₂ with a refractive index lower than the porous silicone oxide, on the optical incident surface of the glass substrate.

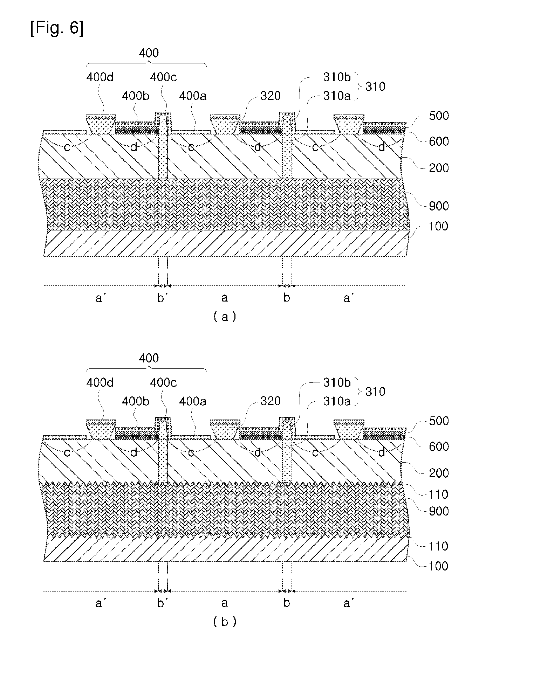

Fig. 6 is a diagram illustrating a solar cell in which a low reflection layer is formed between a substrate and a first semiconductor layer according to one embodiment of the present invention.

With reference to Fig. 6(a), the low reflection layer 900 may be formed between the substrate 100 and the first semiconductor layer 200. The low reflection layer 900 may be formed as a single layer or multiple layers.

The low reflection layer 900 may be any one of SiₓN_{y}, SiOₓN_{y}, Al₂O₃, MgO, TiO₂, SiO₂, SnOₓ and MgFₓ, but the present invention is not limited thereto. The refractive index of the low reflection layer 900 is preferably adjusted between those of the substrate 100 and the first semiconductor layer 200. The method of forming the low reflection layer 900 may use physical vapor deposition (PVD), chemical vapor deposition (CVD) and the like, but the present invention is not limited thereto and well-known thin film forming methods may be used without limitation.

With reference to Fig. 6(b), the low reflection layer 900 is formed between the substrate 100 and the first semiconductor layer 200, and the textured pattern 110 may be further formed between the substrate 100 and the low reflection layer 900 and between the low reflection layer 900 and the first semiconductor layer 200. Herein, the textured pattern 110 may be formed on the substrate 100, or on only one side or both sides of the low reflection layer 900. Further, if the textured pattern 110 is formed on the substrate 100, the textured pattern 110 may also be consequently formed on one side or both sides of the low reflection layer 900 when the low reflection layer 900 is stacked on the substrate 100.

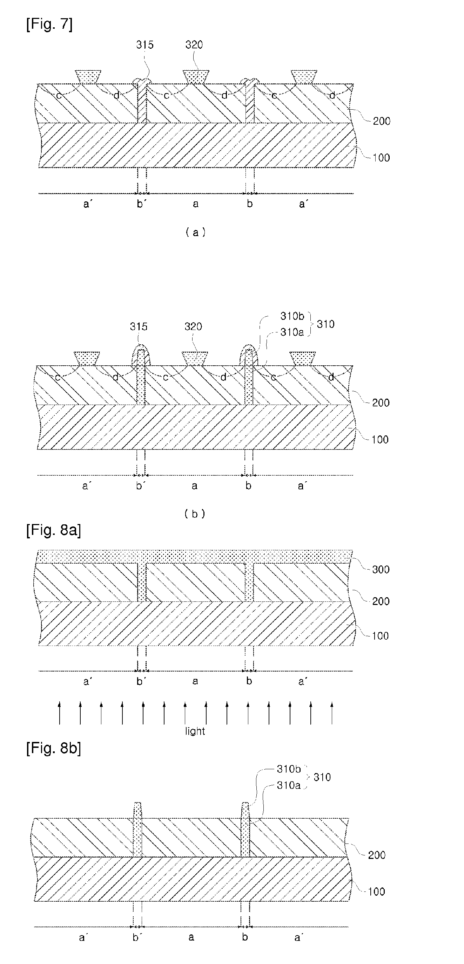

Fig. 7 is a diagram illustrating a solar cell in which an insulation layer is formed according to one embodiment of the present invention.

In the solar cell completed by patterning the first semiconductor layer 200 as illustrated in Fig. 2b, electric current may be leaked since the current density is increased at the edges of the pattern. Therefore, the current leakage may be prevented by forming an insulation layer 315 that covers the edges of the first semiconductor layer 200 patterned as illustrated in Fig. 7. The insulation layer 315 may be any one of SiOₓ, SiNₓ, polymer and photoresist, but the present invention is not limited thereto, and any material that can serve as an insulation layer may be included.

In specific, with reference to Fig. 7(a), the insulation layer 315 may be formed using physical vapor deposition (PVD), chemical vapor deposition (CVD), photolithography, printing or the like, without performing double-sided exposure at the stage of Fig. 2d, so that the patterned portions of the first semiconductor layer 200 are first covered. Thereafter, only the partition layer 320 may be formed by exposing only the upper side of the negative photoresist layer 300 using a photo mask. Of course, in order to form the insulation layer 315 with a photoresist, the double-sided exposure is performed at the stage of Fig. 2d and the photo mask on the upper side of the negative photoresist layer 300 is changed so that the partition layer 320 and the insulation layer 315 may be simultaneously formed. Further, as illustrated in Fig. 7(b), the insulation layer 315 may also be formed on the upper side of the separation layer 310 after the stage of Fig. 2e.

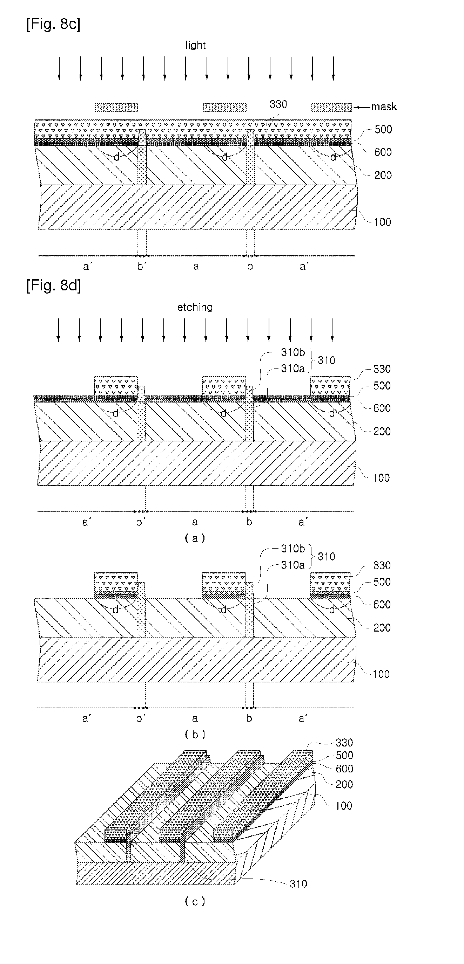

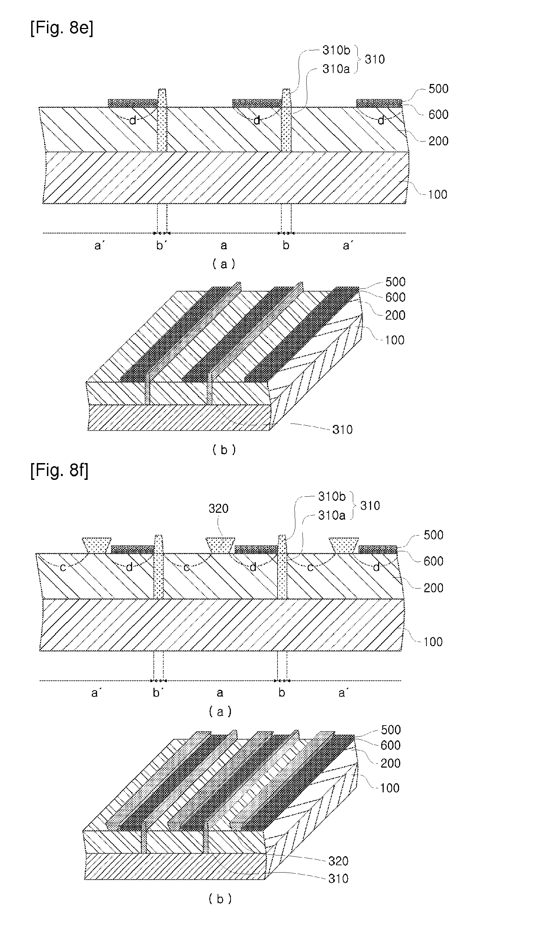

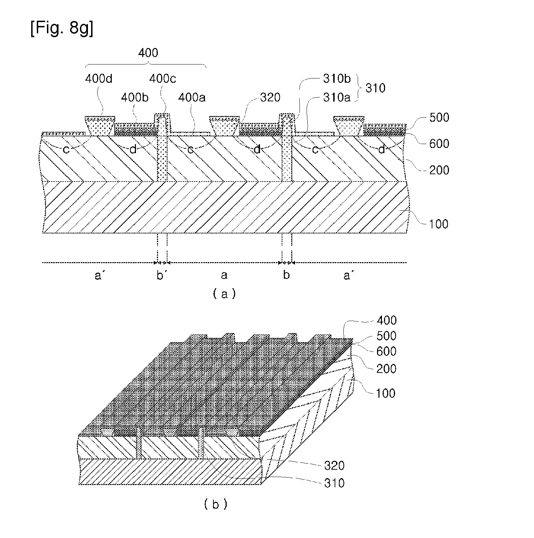

Figs. 8a to 8g are diagrams sequentially illustrating procedures of fabricating a solar cell according to another embodiment of the present invention. In the following description of Fig. 8, only the differences with Fig. 2 will be described, and repetitive descriptions will be omitted.

First, with reference to Fig. 8a, the negative photoresist layer 300 is formed on the first semiconductor layer 200 on the unit cell regions (a) of the substrate 100 and on the wiring regions (b), and only the lower side of the negative photoresist layer 300 is exposed using the first semiconductor layer 200 as a photo mask.

Next, with reference to Fig. 8b, unexposed portions of the negative photoresist layer 300 are removed using a developer. As a result, separation layers 310 (310a and 310b) may be formed on the wiring regions (b).

Subsequently, with reference to Fig. 8c, the buffer layer 600 and the second semiconductor layer 500 are sequentially formed on the first semiconductor layer 200, and a photoresist layer 330 is formed on the second semiconductor layer 500. The photoresist layer 330 may be formed as a positive photoresist layer or a negative photoresist layer without limitation, but the present embodiment is described under the assumption that it is formed as a positive photoresist layer. After the positive photoresist layer 330 is formed, the upper side of the positive photoresist layer 330 is exposed using a photo mask. Herein, the second region (d) is masked by the photo mask so that the positive photoresist layer 330 remains on the second semiconductor layer 500 of the second region (d) after development.

Thereafter, with reference to Figs. 8d(a) and 8d(b), the second semiconductor layer 500 and the buffer layer 600 are etched so that they remain on the second region (d). Herein, the separation layer 310 and the positive photoresist layer 330 are not etched. The above-described etching method may include dry etching, wet etching and the like, but the present invention is not limited thereto, and well-known thin film etching methods may be used without limitation. Fig. 8d(c) is a diagram illustrating Fig. 8d(b) in three dimensions.

Next, with reference to Fig. 8e(a), the positive photoresist layer 330 on the second semiconductor layer 500 is removed. Fig. 8e(b) is a diagram illustrating Fig. 8e(a) in three dimensions.

Subsequently, with reference to Fig. 8f(a), the partition layer 320 is formed on the first semiconductor layer 200. The partition layer 320 is formed with a photoresist by photolithography.

The buffer layer 600 and the second semiconductor layer 500 may be formed by ink jet printing, screen printing, direct deposition using a shadow mask, or the like, without using photolithography. However, the present invention is not limited to the above-described methods, and well-known thin film forming and patterning methods may be used without limitation. Fig. 8f(b) is a diagram illustrating Fig. 8f(a) in three dimensions.

Subsequently, with reference to Fig. 8g(a), the electrode layer 400 is formed on the first semiconductor layer 200, the separation layer 310, the partition layer 320 and the second semiconductor layer 500. Meanwhile, the process of forming the partition layer 320 of Fig. 8f may be omitted, and the electrode layer 400 may also be formed by inkjet printing, screen printing, direct deposition using a shadow mask, or the like. Fig. 8f(b) is a diagram illustrating Fig. 8f(a) in three dimensions.

In the foregoing detailed description, although the present invention has been described with specific limitations such as detailed components as well as limited embodiments and drawings, these are merely provided to aid general understanding of the invention. The present invention is not limited to the above embodiments, and those of ordinary skill in the art will appreciate that various modifications and changes are possible from the above description. Therefore, the spirit of the present invention shall not be limited to the embodiments described above, and the entire scope of the appended claims and their equivalents will fall within the scope and spirit of the invention.

## Claims

1. A solar cell comprising:
a substrate including a plurality of unit cell regions and a plurality of wiring regions positioned between the unit cell regions;
a first semiconductor layer being formed on any one unit cell region of the plurality of unit cell regions;
a partition layer being formed on the first semiconductor layer and partitioning a region on the first semiconductor layer into first and second regions;
a separation layer being formed on any one wiring region of the plurality of wiring regions;
a first electrode layer being formed on the first region of the first semiconductor layer;
a second semiconductor layer being formed on the second region of the first semiconductor layer;
a second electrode layer being formed on the second semiconductor layer; and
an electrode connection layer being connected to one end of the second electrode layer as the same layer and being formed on the separation layer.

2. The solar cell according to Claim 1, wherein the substrate includes any one of glass and plastic.

3. The solar cell according to Claim 1, wherein at least one side of the substrate is textured.

4. The solar cell according to Claim 1, wherein nano-holes are formed between the substrate and the first semiconductor layer.

5. The solar cell according to Claim 1, wherein the first semiconductor layer is a p-type semiconductor layer.

6. The solar cell according to Claim 5, wherein the first semiconductor layer includes any one of CIGS (copper indium gallium selenide), CdTe and CZTS (copper zinc tin selenide).

7. The solar cell according to Claim 1, wherein the partition layer is a photoresist layer with a reverse trapezoidal shape.

8. The solar cell according to Claim 1, wherein the first electrode layer, the second electrode layer and the electrode connection layer include any one of Mo, Al, Ag, Au, Cu, Pt, Ni, Pd, Ti, Sn, Sb, Co, Tr, Ru, Rh and Cd.

9. The solar cell according to Claim 1, wherein the second semiconductor layer is an n-type semiconductor layer.

10. The solar cell according to Claim 9, wherein the second semiconductor layer includes any one of metal oxide including ZnO and ZrO, metal nitride including GaN, metal hydrate including In(OH)ₓS_{y}, MeₓZn_{y}(OH)_{z}S_{q}, MeₓIn_{y}(OH)_{z}S_{q}, MeₓZn_{y}(OH)_{z}Se_{q} and MeₓIn_{y}(OH)_{z}Se_{q}, amorphous silicon, conducting polymer, and semiconducting organic material.

11. The solar cell according to Claim 1, further comprising:
a hole injection layer being formed between the first semiconductor layer and the first electrode layer.

12. The solar cell according to Claim 11, wherein a work function of the hole injection layer ranges between those of the first semiconductor layer and the first electrode layer, and the hole injection layer includes any one of metal, metal oxide, metal nitride, metal sulfide, metal chelate, and organic material.

13. The solar cell according to Claim 12, wherein the work function of the hole injection layer is from 3.0 eV to 7.0 eV.

14. The solar cell according to Claim 1, further comprising:
a buffer layer being formed between the first semiconductor layer and the second semiconductor layer.

15. The solar cell according to Claim 14, wherein an energy band of the buffer layer ranges between those of the first semiconductor layer and the second semiconductor layer, and the buffer layer includes any one of metal, metal alloy, metal oxide including ZnOₓ, metal nitride including GaN and MeₓGa_{y}N_{z}, metal hydrate including Zn(OH)ₓ, metal sulfide including CdS, ZnSₓ, In(OH)ₓS_{y}, InS, MeₓZn_{y}(OH)_{z}S_{q} and MeₓIn_{y}(OH)_{z}S_{q}, metal selenide including ZnSe, PbSe, MeₓZn_{y}(OH)_{z}Se_{q} and MeₓIn_{y}(OH)_{z}Se_{q}, conducting polymer, and semiconducting organic material.

16. The solar cell according to Claim 1, wherein the separation layer comprises a first separation layer being formed to have a thickness substantially the same as that of the first semiconductor layer, and a second separation layer being formed at one end of the first separation layer as the same layer.

17. The solar cell according to Claim 16, wherein the second separation layer is a photoresist layer with a trapezoidal shape.

18. The solar cell according to Claim 17, wherein the electrode connection layer is formed on the second separation layer.

19. The solar cell according to Claim 1, wherein the electrode connection layer is connected as the same layer to one end of a first electrode layer being formed on a unit cell region neighboring the one unit cell region.

20. The solar cell according to Claim 19, wherein by means of the electrode connection layer, the one unit cell region and the unit cell region neighboring the one unit cell region are electrically connected in series, and all the unit cell regions on the substrate are electrically connected in series.

21. The solar cell according to Claim 1, further comprising:
a low reflection layer being formed between the substrate and the first semiconductor layer.

22. The solar cell according to Claim 21, wherein the low reflection layer includes a material of which a refractive index ranges between those of the substrate and the first semiconductor layer.

23. The solar cell according to Claim 22, wherein the low reflection layer includes at least one of SiₓN_{y}, SiOₓN_{y}, Al₂O₃, MgO, TiO₂, SiO₂, SnOₓ and MgFₓ.

24. The solar cell according to Claim 1, wherein the separation layer covers edges of the first semiconductor layer and serves as an insulation layer.

25. The solar cell according to Claim 1, further comprising:
an insulation layer being formed on the separation layer and covering edges of the separation layer and the first semiconductor layer.

26. The solar cell according to Claim 24 or 26, wherein the insulation layer includes at least one of SiOₓ, SiNₓ, polymer and photoresist.

27. A method for fabricating a solar cell, comprising:
(a) providing a substrate including a plurality of unit cell regions and wiring regions positioned between the unit cell regions;
(b) forming a first semiconductor layer on any one unit cell region of the plurality of unit cell regions;
(c) simultaneously forming a partition layer on the first semiconductor layer and a separation layer on any one wiring region of the plurality of wiring regions;
(d) when a region on the first semiconductor layer is partitioned into first and second regions by the partition layer, forming a second semiconductor layer on the second region; and
(e) forming a first electrode layer on the first semiconductor layer, a second electrode layer on the second semiconductor layer, and an electrode connection layer on the separation layer.

28. A method for fabricating a solar cell, comprising:
(a) providing a substrate including a plurality of unit cell regions and a plurality of wiring regions positioned between the unit cell regions;
(b) forming a first semiconductor layer on any one unit cell region of the plurality of unit cell regions;
(c) forming a separation layer on any one wiring region of the plurality of wiring regions;
(d) when a region on the first semiconductor layer is partitioned into first and second regions by a partition layer to be formed on the first semiconductor layer, forming a second semiconductor layer on the second region;
(e) forming the partition layer on the first semiconductor layer; and
(f) forming a first electrode layer on the first semiconductor layer, a second electrode layer on the second semiconductor layer, and an electrode connection layer on the separation layer.

29. The method according to Claim 27 or 28, wherein the substrate includes any one of glass and plastic.

30. The method according to Claim 27 or 28, wherein at least one side of the substrate is textured.

31. The method according to Claim 27 or 28, wherein nano-holes are formed between the substrate and the first semiconductor layer.

32. The method according to Claim 27 or 28, wherein the first semiconductor layer is a p-type semiconductor layer.

33. The method according to Claim 32, wherein the first semiconductor layer includes any one of CIGS (copper indium gallium selenide), CdTe and CZTS (copper zinc tin selenide).

34. The method according to Claim 27 or 28, wherein the partition layer is a photoresist layer with a reverse trapezoidal shape.

35. The method according to Claim 27 or 28, wherein the first electrode layer, the second electrode layer and the electrode connection layer include any one of Mo, Al, Ag, Au, Cu, Pt, Ni, Pd, Ti, Sn, Sb, Co, Tr, Ru, Rh and Cd.

36. The method according to Claim 27 or 28, wherein the second semiconductor layer is an n-type semiconductor layer.

37. The method according to Claim 36, wherein the second semiconductor layer includes any one of metal oxide including ZnO and ZrO, metal nitride including GaN, metal hydrate including In(OH)ₓSy, MeₓZn_{y}(OH)_{z}S_{q}, MeₓIn_{y}(OH)_{z}S_{q}, MeₓZn_{y}(OH)_{z}Seq and MeₓIn_{y}(OH)_{z}Se_{q}, amorphous silicon, conducting polymer, and semiconducting organic material.

38. The method according to Claim 27 or 28, further comprising:
forming a hole injection layer between the first semiconductor layer and the first electrode layer.

39. The method according to Claim 38, wherein a work function of the hole injection layer ranges between those of the first semiconductor layer and the first electrode layer, and the hole injection layer includes any one of metal, metal oxide, metal nitride, metal sulfide, metal chelate, and organic material.

40. The method according to Claim 39, wherein the work function of the hole injection layer is from 3.0 eV to 7.0 eV.

41. The method according to Claim 27 or 28, further comprising:
forming a buffer layer between the first semiconductor layer and the second semiconductor layer.

42. The method according to Claim 41, wherein an energy band of the buffer layer ranges between those of the first semiconductor layer and the second semiconductor layer, and the buffer layer includes any one of metal, metal alloy, metal oxide including ZnOₓ, metal nitride including GaN and MeₓGa_{y}N_{z}, metal hydrate including Zn(OH)ₓ, metal sulfide including CdS, ZnSₓ, In(OH)ₓS_{y}, InS, MeₓZn_{y}(OH)_{z}S_{q} and MeₓIn_{y}(OH)_{z}S_{q}, metal selenide including ZnSe, PbSe, MeₓZn_{y}(OH)_{z}Se_{q} and MeₓIn_{y}(OH)_{z}Se_{q}, conducting polymer, and semiconducting organic material.

43. The method according to Claim 27 or 28, wherein the separation layer comprises a first separation layer formed to have a thickness substantially the same as that of the first semiconductor layer, and a second separation layer being formed at one end of the first separation layer as the same layer.

44. The method according to Claim 43, wherein the second separation layer is a photoresist layer with a trapezoidal shape.

45. The method according to Claim 27 or 28, wherein the electrode connection layer is connected as the same layer to one end of a first electrode layer being formed on a unit cell region neighboring the one unit cell region.

46. The method according to Claim 45, wherein by means of the electrode connection layer, the one unit cell region and the unit cell region neighboring the one unit cell region are electrically connected in series, and all the unit cell regions on the substrate are electrically connected in series.

47. The method according to Claim 27 or 28, further comprising:
forming a low reflection layer between the substrate and the first semiconductor layer.

48. The method according to Claim 47, wherein the low reflection layer includes a material of which a refractive index ranges between those of the substrate and the first semiconductor layer.

49. The method according to Claim 48, wherein the low reflection layer includes at least one of SiₓN_{y}, SiOₓN_{y}, Al₂O₃, MgO, TiO₂, SiO₂, SnOₓ and MgFₓ.

50. The method according to Claim 27 or 28, wherein the separation layer covers edges of the first semiconductor layer and serves as an insulation layer.

51. The method according to Claim 50, wherein the insulation layer includes at least one of SiOₓ, SiNₓ, polymer and photoresist.

52. The method according to Claim 27 or 28, further comprising:
an insulation layer being formed on the separation layer and covering edges of the separation layer and the first semiconductor layer.

53. The method according to Claim 52, wherein the insulation layer includes at least one of SiOₓ, SiNₓ, polymer and photoresist.
